# EUROPÄISCHE PATENTSCHRIFT

(11) **EP 4 068 913 B1**
(45) Veröffentlichungstag und Bekanntmachung des Hinweises auf die Patenterteilung: **01.10.2025**
(21) Anmeldenummer: 21166339.8
(22) Anmeldetag: 31.03.2021
(51) Int. Cl.: H05K 1/02, H05K 3/00, B33Y 10/00, B33Y 80/00, B29C 64/393, H05K 3/46

(54) **ADDITIV-GEFERTIGTE STRUKTUR UND VERFAHREN ZU DEREN HERSTELLUNG**
STRUCTURE PRODUCED BY MEANS OF ADDITIVE MANUFACTURING AND METHOD FOR PRODUCING THE SAME
STRUCTURE FABRIQUÉE DE MANIÈRE ADDITIVE ET SON PROCÉDÉ DE FABRICATION

(43) Veröffentlichungstag der Anmeldung: 05.10.2022
(73) Patentinhaber: HENSOLDT Sensors GmbH, 82024 Taufkirchen (DE)
(72) Erfinder: Sander, Jörg, 89075 Ulm (DE); Baltes, Rolf, 81829 München (DE); Salomon, Andreas, 81925 München (DE); Zimmer, Felix, 85435 Erding (DE); Hehn, Tobias, 97723 Oberthulba (DE)
(74) Vertreter: LifeTech IP Spies & Behrndt Patentanwälte PartG mbB

(56) Entgegenhaltungen:
- CN-A- 105 813 382
- JP-A- H0 232 594
- JP-A- H04 122 842
- US-A1- 2017 179 607
- US-A1- 2019 134 892

## Beschreibung

Die vorliegende Erfindung bezieht sich auf eine additiv-gefertigte Struktur und ein Verfahren zu deren Herstellung und insbesondere auf einen Positionsmarker für additiv-gefertigte zwei- oder mehrteilige Strukturen für eine additiv-gefertigte Elektronik.

### HINTERGRUND

Für eine additiv-gefertigte Elektronik kann ein Drucksystem nach dem Multi-Jet-Verfahren genutzt werden, bei dem mindestens zwei Tinten verarbeitet werden. In der Minimalkonfiguration ist eine der beiden Tinten ist eine nichtleitfähige Tinte, die andere Tinte ist elektrisch leitfähig und umfasst leitfähige Nanopartikel, die im Druckprozess zu leitfähigen Bahnen versintert werden. Um auf eine additiv-gefertigte Platine elektronische Komponenten oder Bauelemente (Mikrocontroller, Widerstände, Kondensatoren etc.) aufbringen zu können, werden die elektronischen Komponenten mit einem Pick-&-Place-Verfahren auf die Platine gesetzt und verlötet.

Für solche Drucker können Bauräume für Platinen von beispielsweise 160 mm x 160 mm x 3 mm erreicht werden, wobei ein Bestreben darin besteht, auch größere Höhen zu realisieren, um die Vorteile des dreidimensionalen (3D-) Aufbaus nutzen zu können. Es besteht insbesondere ein Bedarf nach Platinen, die nicht mehr nur planar aufgebaut werden, sondern auch dreidimensional in jedem beliebigem bzw. benötigtem Formfaktor gestaltet werden können. Dies ermöglicht höhere Integrationsdichten, Schirmungen, elektromechanische Schlüssel, Spionageschutzmechanismen u.v.m.

Mit konventionellen Verfahren lassen sich Bauelemente lediglich an der Ober- und Unterseite der Platine bestücken. Um Bauelemente in Schaltungsträger (z.B. in einem Würfel) zu bekommen, wird zunächst ein erster Teilkörper gedruckt, der entsprechende Taschen für die benötigten Komponenten enthält. Der Druckvorgang wird zum Bestücken unterbrochen und anschließend nach dem Bestücken fortgeführt. Dieses Bestücken kann derzeit ausschließlich außerhalb des Druckers stattfinden, wodurch die Platine samt Bauplattform vor dem Bestücken aus dem Drucker entnommen und nach dem Bestücken wiedereingesetzt wird. Nach dem Wiedereinsetzten ist es wichtig, dass der Drucker sehr präzise auf dem bisherigen ersten Teilkörper weiterdruckt. Nur so ist sichergestellt, dass die Kontaktverbindungen in einem ausreichenden Maß überlappen und eine ausreichend gute Durchkontaktierung in vertikaler Aufbaurichtung (Z-Richtung) ermöglicht wird.

Diese "Job-on-Job" - Präzision kann derzeit lediglich durch sehr zeit- und kostenaufwändige Computertomographische Untersuchungen im Anschluss an den 3D-Druck überprüft werden. Daher besteht ein Nachteil im konventionellen Druck in dem großen technischen und zeitlichen Aufwand, der für diese Art von Qualitätskontrolle erforderlich ist. Außerdem kann diese Qualitätskontrolle erst im Anschluss an den Druckprozess durchgeführt werden. Ein eventuell erforderliches Anpassen während dem Druckvorgang ist nicht möglich.

Weitere konventionelle additive Fertigungsstrukturen sind in den folgenden Dokumenten offenbart. JP H04 122842 A offenbart ein Verfahren zum Ausrichten von Verschaltungsschichten, ohne dass dort ein zweiter Teilkörper auf einen ersten Teilkörper additiv gefertigt wird. JP H02 32594 A offenbart eine laminierte Leiterplattenstruktur, ohne dass dort ein zweiter Teilkörper auf einen ersten Teilkörper additiv gefertigt wird. CN 105 813 382 A offenbart eine eingebettete Schaltung und ein Verfahren zum Einbetten einer Schaltung, ohne dass dort ein zweiter Teilkörper auf einen ersten Teilkörper additiv gefertigt wird. US 2019/134892 A1 offenbart ein verbessertes Verfahren zum Kalibrieren für die Herstellung einer Vorrichtung. Auch hier wird kein zweiter Teilkörper auf einen ersten Teilkörper additiv gefertigt. US 2017/179607 A1 offenbart eine Schaltungsplatine für Hochfrequenzanwendungen mit einer integrierten Breitbandantenne, ohne dass dort ein zweiter Teilkörper auf einen ersten Teilkörper additiv gefertigt wird, deren Versatz mit einem Nonius-basierten Positionsmarker angezeigt wird.

Somit besteht ein Bedarf nach alternativen Vorgehensweisen, mit welchen die genannte Job-on-Job Präzision mit deutlich geringerem Aufwand überprüft werden kann. Ebenso besteht ein Bedarf nach Möglichkeiten, mittels optischer Systeme oder gar dem menschlichen Auge eine schnelle und einfache 100 % Qualitätssicherung der Job-on-Job-Präzision durchführen zu können

### KURZBESCHREIBUNG DER ERFINDUNG

Zumindest ein Teil der oben genannten Probleme wird durch eine additiv-gefertigte Struktur nach Anspruch 1 und ein Verfahren nach Anspruch 12 gelöst. Die abhängigen Ansprüche beziehen sich auf vorteilhafte Weiterbildungen der Gegenstände der unabhängigen Ansprüche.

Die vorliegende Erfindung bezieht sich auf eine Struktur, die Folgendes aufweist: mehrere Teilkörper und einen Nonius-basierten Positionsmarker. Die mehreren Teilkörper umfassen einen ersten Teilkörper, einen zweiten Teilkörper und zumindest eine elektronische Komponente. Der zweite Teilkörper ist zumindest teilweise auf dem ersten Teilkörper additiv gefertigt. Der Nonius-basierte Positionsmarker ist ausgebildet, um einen relativen Versatz zwischen dem ersten Teilkörper und den zweiten Teilkörper anzuzeigen.

Die Struktur soll insbesondere einen beliebigen Bestandteil einer 3D-gerfertigten Elektronik umfassen, wozu z.B. Folgendes gehört: Schaltungsplatinen für elektronische Bauteile (aktiv oder passiv), elektrische Verbindungen, Antennen, Wellenleiter etc.

Unter einem Nonius-basierten Positionsmarker sollen Anzeigemittel verstanden sein, die auf dem Nonius-Prinzip basieren, um ein Versatz (oder eine Verschiebung/Verdrehung) anzuzeigen. Das Nonius-Prinzip basiert auf zwei periodische Strukturen (z.B. Strichskalen oder Gitter) mit unterschiedlicher Periodizität in zumindest einer Richtung. Im einfachsten Fall sind es wie bei einem Messschieber zwei nebeneinanderliegende Strichskalen, wovon bei einen der Abstand (Periodizität) der Striche 1 mm beträgt und bei der anderen 0,9 mm beträgt. Wenn die Strichskalen zumindest 10 Striche aufweisen, kann damit ein Versatz der beiden Strichskalen auf 0,1 mm genau erfasst werden. Das ist nur ein Beispiel. Die beiden Skalen können beliebig zueinander skaliert sein.

Der Begriff "Versatz" soll im Rahmen der vorliegenden Erfindung nicht nur eine lineare Verschiebung umfassen, sondern auch Verdrehungen oder kombinierte Bewegungen umfassen.

Der erste Teilkörper muss nicht additiv gefertigt sein, es kann sich auch um eine fertige Platine oder um eine konventionelle Leiterplatte handeln. Vorteilhafterweise ist aber das erste Nonius-Muster darauf additiv gefertigt, um eine möglichst genaue Positionierung während des gesamten additiven Fertigungsprozesses zu erreichen.

Optional umfasst der Positionsmarker ein erstes Nonius-Muster und ein zweites Nonius-Muster, wobei das erste Nonius-Muster auf dem ersten Teilkörper und das zweite Nonius-Muster auf dem zweiten Teilkörper ausgebildet ist.

Optional ist das erste Nonius-Muster auf einer Oberseite des ersten Teilkörpers und das zweite Nonius-Muster auf einer Unterseite des zweiten Teilkörpers ausgebildet, wobei die Unterseite und die Oberseite einander zugewandt sind. Hierdurch kann ein Parallaxenfehler minimiert werden.

Optional umfasst das erste Nonius-Muster und/oder das zweite Nonius-Muster jeweils ein Gitter oder jeweils zumindest eine Nonius-Skala, um einen Versatz in einer oder beiden Richtungen senkrecht zur additiven Fertigungsrichtung anzuzeigen. Obwohl in der Regel beide Nonius-Muster gleich ausgebildet sein können, sollen Ausführungsbeispiele auch die Form umfassen, wo ein Gitter mit einem oder mehreren Strichskalen kombiniert wird. Vorteilhafterweise liegen die Nonius-Muster übereinander oder grenzen aneinander.

Optional umfasst die zumindest eine Nonius-Skala zumindest eine erste Seitenskala auf einer Seitenfläche des ersten Teilkörpers und zumindest eine zweite Seitenskala auf einer Seitenfläche des zweiten Teilkörpers, wobei beide Seitenflächen eine seitliche Begrenzung der Struktur nach der Fertigstellung bilden. Die Nonius-Skalen können hier durch zwei angrenzende Strichskalen gebildet sein.

Optional umfassen die Teilkörper zumindest an einer Position (Region) des Positionsmarkers ein transparentes Material, um eine optische Erfassung mittels eines optischen Sensors (z.B. eine Kamera) zu ermöglichen. Der Versatz kann auch durch einen Nutzer durch eine Inaugenscheinnahme erfasst werden.

Optional umfassen die Teilkörper zumindest an einer Position (oder Region) des Positionsmarkers ein dielektrisches Material und der Positionsmarker (z.B. Nonius-Muster) umfasst ein elektrisch leitfähiges Material, um eine elektrische Erfassung des Versatzes zu ermöglichen. Die elektrische Erfassung kann über den elektrischen Widerstand (wenn ein direkter Kontakt vorliegt), die Kapazität (wenn kein direkter Kontakt vorliegt) oder über eine gemessene Induktivität erfolgen. Optional ist der Positionsmarker ein Linearencoder, der kapazitiv eine Linearverschiebung misst.

Optional ist der Positionsmarker ein erster Positionsmarker und die Struktur umfasst zusätzlich einen zweiten Nonius-basierten Positionsmarker, der von dem ersten Positionsmarker beabstandet ist. Der erste und der zweite Positionsmarker können einen gleichen Aufbau aufweisen und sind möglichst weit voneinander entfernt ausgebildet (z.B. an gegenüberliegenden Seiten). Dadurch kann Genauigkeit, insbesondere bei Verdrehungen, erhöht werden.

Ausführungsbeispiele beziehen sich auch auf eine Vorrichtung nach Anspruch 10.

Ausführungsbeispiele beziehen sich auch auf ein Verfahren nach Anspruch 11.

Das Verfahren umfasst:
- Bereitstellen eines ersten Teilkörpers mit einem ersten Nonius-Muster;
- Bestücken des ersten Teilkörpers mit einer elektronischen Komponente;
- Additives Fertigen eines zweiten Teilkörpers, wobei ein zweites Nonius-Muster auf dem zweiten Teilkörper gefertigt wird,
- Anzeigen eines relativen Versatzes zwischen dem ersten Teilkörper und dem zweiten Teilkörper durch einen Positionsmarker, der aus dem erste Nonius-Muster und dem zweites Nonius-Muster gebildet wird.

Optional umfasst das Bereitstellen eines ersten Teilkörpers: ein additives Fertigen des ersten Teilkörpers zusammen mit dem ersten Nonius-Musters. Das Bestücken des ersten Teilkörpers kann Folgendes umfassen: Entnahme des additiv-gefertigten ersten Teilkörper aus einer additive Fertigungsvorrichtung; Bestücken des ersten Teilkörper mit der elektronischen Komponente; und Wiedereinsetzen des ersten Teilkörpers zusammen mit der elektronischen Komponente in die additive Fertigungsvorrichtung.

Optional umfasst das Verfahren ein Ermitteln eines Versatzes unter Nutzung des Positionsmarkes. Das Ermitteln kann optisch mittels eines optischen Sensors oder einer Kamera erfolgen und ein Durchleuchten oder einen Laser-Scan umfassen. Das Ermitteln kann auch oder zusätzlich mittels elektrischer Signale, d.h. über Messung des Widerstandes, einer Kapazität, einer Resonanz, Induktivität etc. erfolgen.

Optional wird das additive Fertigen des zweiten Teilkörpers erst nach dem Ermitteln des Versatzes beendet. Bei Überschreiten eines Schwellenwertes kann eine Korrektur vorgenommen werden.

Ausführungsbeispiele lösen zumindest einen Teil der eingangs genannten Probleme durch einen Positionsmarker nach dem Nonius-Prinzip, wozu zwei Muster in beide Teilkörper eingebracht werden. Ein Nonius ermöglicht eine deutlich genauere Bestimmung von Positionsabweichungen als es durch das Betrachten zweier übereinanderliegenden einfachen Markern möglich wäre.

Die Struktur ist beispielsweise ein additiv gefertigter Schaltungsträger (z.B. eine Leiterplatte). Gemäß Ausführungsbeispiele kann der Druckprozess unterbrochen werden, um beispielsweise elektronische Bauteile hinzufügen, und wird präzise an derselben Stelle fortgesetzt. Ausführungsbeispiele erlauben auch ein Qualitätssicherungsverfahren, um die Präzision des Weiterdruckens verifizieren zu können.

### KURZBESCHREIBUNG DER FIGUREN

Die Ausführungsbeispiele der vorliegenden Erfindung werden besser verstanden anhand der folgenden detaillierten Beschreibung und durch die beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt eine schematische Ansicht einer additiv-gefertigten Struktur gemäß einer Ausführungsform der vorliegenden Erfindung.
- Fig. 2A-2C: zeigen weitere Ausführungsbeispiele für undurchsichtige Strukturen und für eine 2-dimensionalen Positionsbestimmung.
- Fig. 3: zeigt eine detailliertere Darstellung eines Nonius-Gitters gemäß weiterer Ausführungsbeispiele.
- Fig. 4: zeigt eine mögliche Anordnung der Nonius-Gitter in den Teilkörpern.
- Fig. 5: zeigt ein Ausführungsbeispiel für ein elektrisches Auslesen der Positionsgenauigkeit.
- Fig. 6: zeigt ein schematisches Flussdiagramm für ein Verfahren gemäß Ausführungsbeispielen.

### DETAILLIERTE BESCHREIBUNG

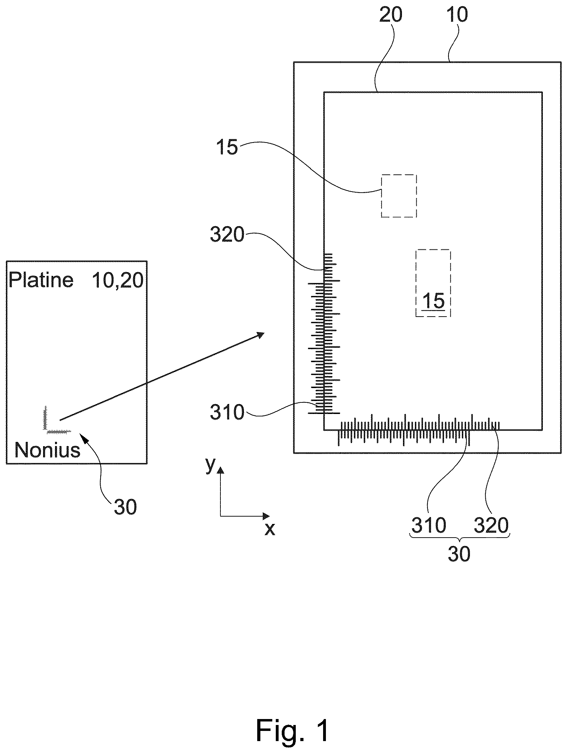

**Fig. 1** zeigt eine schematische Ansicht einer additiv-gefertigten Struktur gemäß einer Ausführungsform, wobei die Struktur mehrere Teilkörper 10, 20, zumindest eine elektronische Komponente 15 und einen Nonius-basierten Positionsmarker 30 umfasst. Die Teilkörper 10, 20 umfassen einen ersten Teilkörper 10, auf dem ein zweiter Teilkörper 20 additiv gefertigt wurde, so dass die elektronische Komponente 15 in den beiden Teilkörpern 10, 20 eingebettet ist.

Die elektronische Komponente 15 kann beispielsweise auf dem ersten Teilkörper 10 oder auch auf dem zweiten Teilkörper 15 angebracht oder installiert werden. Typischerweise erfolgt dies außerdem einer Vorrichtung, die zur additiven Fertigung genutzt wird (z.B. in einer Bestückungsmaschine).

Der Nonius-basierte Positionsmarker 30 ist ausgebildet, um einen relativen Versatz zu erfassen, wobei der Versatz zumindest eines aus dem Folgenden umfassen kann: eine Verschiebung entlang einer ersten horizontalen Richtung X und/oder einer zweiten horizontalen Richtung Y, eine Verdrehung um eine vertikalen Achse Z (additive Fertigungsrichtung). Der Positionsmarker 30 umfasst beispielhaft ein erstes Nonius-Muster 310 auf dem ersten Teilkörper 10 und ein zweites Nonius-Muster 320 auf dem zweiten Teilkörper 20.

Das erste und zweite Nonius-Muster 310, 320 umfassen in dieser Ausführungsform beispielhaft jeweils eine Strichskala mit unterschiedlich Strichabständen, sodass eine Verschiebung des ersten Teilkörpers 10 relativ zu dem zweiten Teilkörper 20 feststellbar ist. Wenn beispielsweise die ersten Striche der Strichskalen 310, 320 übereinstimmen, liegt kein Versatz vor, wenn jedoch andere Striche der beiden Skalenskalen 310, 320 übereinstimmen, liegt ein entsprechender Versatz vor, der davon abhängt, welche der gezeigten Striche miteinander übereinstimmen (Nonius-Prinzip).

In der Fig. 1 sind zwei Sätze von Nonius-Muster 310, 320 dargestellt, um einen Versatz sowohl in der X-Richtung als auch in der Y-Richtung festzustellen. Bei weiteren Ausführungsbeispielen ist der gezeigte Positionsmarker 30 ein erster Positionsmarker und ein zweiter Positionsmarker kann an einer weiter entfernten Position ausgebildet werden. Damit wird eine bessere Genauigkeit, insbesondere hinsichtlich Drehungen, erreicht. Um solche Winkelabweichungen möglichst genau zu erfassen, kann der zweite Positionsmarker ein identischer Marker sein und vorzugsweise mit großem Abstand an der beispielhaften Platine ausgebildet sein.

Somit zeigt die Fig. 1 eine einfache Ausgestaltung, wo der Positionsmarker 30 aus zwei übereinander liegenden Nonius-Kreuzen 310, 320 mit unterschiedlichen Rasterweiten besteht.

Die Strichskalen 310, 320 können auch übereinander angeordnet sein, wobei zur Feststellung des Versatz ein (nahezu) transparentes Material an der Position des Positionsmarkers 30 genutzt werden kann bzw. eine elektrische Erfassung durchgeführt wird (siehe unten). Das würde auch die Feststellung der Verdrehung erleichtern.

Um den Parallaxenfehler zu minimieren, kann das erste Nonius-Muster 310 in der Nähe oder auf der oberen Fläche des unteren, ersten Teilkörpers 10 angebracht werden. Das zweite Nonius-Muster 320 wird dann an einer unteren Fläche des oberen, zweiten Teilkörpers 20 angebracht. Durch eine Rechtwinklige Betrachtung von oben, also auf die XY-Ebene, lässt sich so (z.B. mit einem Kamerasystem oder dem bloßen Auge) eine präzise Überprüfung der Positionsabweichung feststellen.

Falls das Dielektrikum (der nichtleitende Teil der Struktur, Platine) ein transparentes Material aufweist, lässt sich diese Kontrolle während des Druckprozesses ermitteln. Falls das Material lichtundurchlässig ist, kann die Kontrolle auch im Nachgang erfolgen.

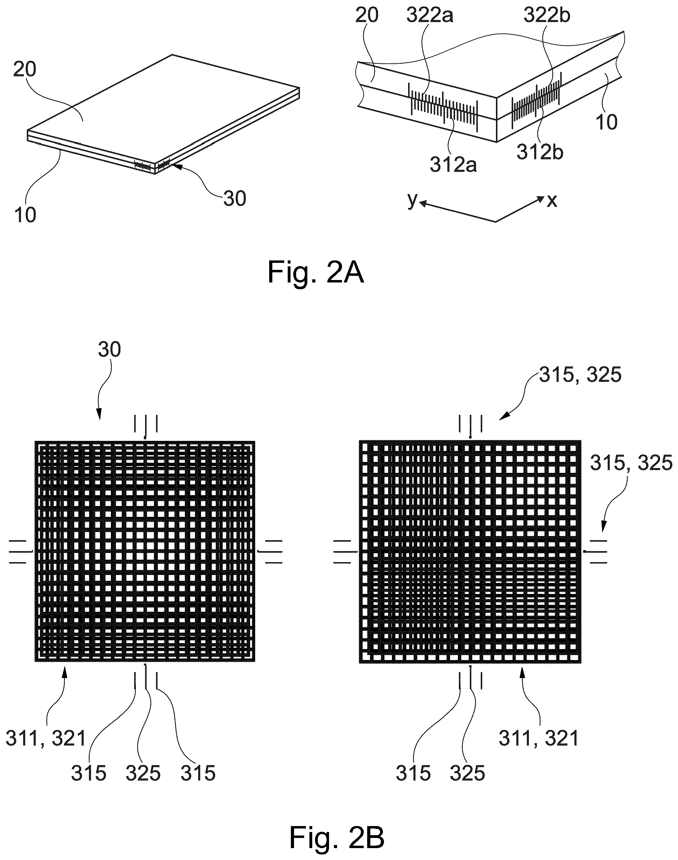

**Fig. 2A** zeigt ein weiteres Ausführungsbeispiel, welches insbesondere für undurchsichtige (opake) Strukturen geeignet ist. Hier umfasst der Positionsmarker 30 die Nonius-Muster 310, 320 an einer Seitenfläche des ersten Teilkörpers 10 und des zweiten Teilkörpers 20, wobei die Seitenflächen nach der Fertigstellung der Struktur eine seitliche Begrenzung (in der X- oder Y-Richtung) der Struktur darstellen.

Der Positionsmarker 30 ist hier auch nach der Fertigstellung der additiv-gefertigten Struktur sichtbar, wobei der Positionsmarker 30 beispielhaft eine erste Nonius-Skala 312a entlang der beispielhaften und eine erste Nonius-Skala 312b entlang der X-Richtung auf dem ersten Teilkörper 10 aufweist. Ebenso ist eine zweite Nonius-Skalen 312a, 312b auf dem zweiten Teilkörper 20 entlang der X- und der ausgebildet. Die erste und zweite Nonius-Skala 312a, 322a in bilden einen Y-Nonius zur Feststellung eines Versatzes in Y-Richtung. Die erste und zweite Nonius-Skala 312a, 322a in X-Richtung bilden einen X-Nonius zur Feststellung eines Versatzes in X-Richtung. Auf anderen Seitenflächen können noch weiter Positionsmarker vorgesehen sein.

Neben der Eignung für nicht-transparentes Material, wird für diesen Positionsmarker kein Platinen-Raum verbraucht. Außerdem können an mehreren oder allen Seitenflächen Nonius-Muster 310, 320 ausgebildet werden, sodass auch Verdrehungen sehr genau erfassbar sind.

Zur automatisierten Überwachung bietet sich eine weiterentwickelte Form des einfachen Positionsmarker 30 an. Hierbei wird statt einer Skala ein Kreuzmuster in Form eines Gitters verwendet, was auch als Nonius-Netz bezeichnet werden kann, wobei die Gitterabstände oder Maschenweiten gezielt eingestellt werden, um eine gewünschte Auflösung zu erreichen. Diese Gitter eignen sich, um eine automatisierte Bildauswertung durchzuführen (z.B. mit einer Kamera), wobei nach einem hellen Bereich oder einem den hellen Bereich umgebenden dunklen Rahmen gesucht wird, um so die Abweichung festzustellen.

**Fig. 2B** zeigt ein Ausführungsbeispiel für einen solchen Positionsmarkers 30, wobei ein erstes Gitter 311 auf dem ersten Teilkörper 10 und ein zweites Gitter 321 auf dem zweiten Teilkörper 20 ausgebildet werden. Die Gitterabstände sind - wie auch bei den Strichskalen 312, 322 - nicht identisch, sondern leicht skaliert, so dass ein relativer Versatz zwischen den beiden Gittern 311, 321 beim Übereinanderlegen sichtbar wird. Es braucht auch kein rechtwinkliges Gitter sein. Es kann dreiecksförmig oder wabenförmig (6-eckig) sein.

Auf der linken Seite in der Fig. 2B ist eine mittige Übereinstimmung der beiden Gitter erkennbar, während auf der rechten Seite eine Verschiebung des zweiten Teilkörpers 20 nach links unten erkennbar ist. Bei perfekter Deckung der beider Gitter (Positionsdifferenz gleich Null) kann sich der helle Bereich genau in der Mitte des Gitters befinden. Bei einer Abweichung verschiebt sich dieser Helle Bereich je nach anteiliger Abweichung in X- und zu einem der beiden Ränder.

Die Gittermuster 311, 321 umfassen weiter jeweils einen Außenmarker 315, 325. Damit kann festgestellt werden, ob die Gitter 311, 321 um mehr als eine Gitterperiode voneinander verschoben sind. Wenn beispielsweise der Mittenstrich 325 sich außerhalb des Bereichs befindet, der durch die Striche 315 gegeben ist, liegt ein Versatz eines Vielfachen des Gitters vor. Hierzu ist der Abstand der beiden Striche 315 gerade die doppelte Periode des zugeordneten Gitters 311, 321. Beispielsweise kann der Mittenstrich 325 dem zweiten Gitter 321 zugeordnet sein, während die beiden Striche 315 dem ersten Gitter 311 zugeordnet sein können. Zum Beispiel ist deren Abstand dann der doppelte Gitterabstand des ersten Gitters 311. Die Zuordnung kann aber auch genau umgekehrt hierzu erfolgen.

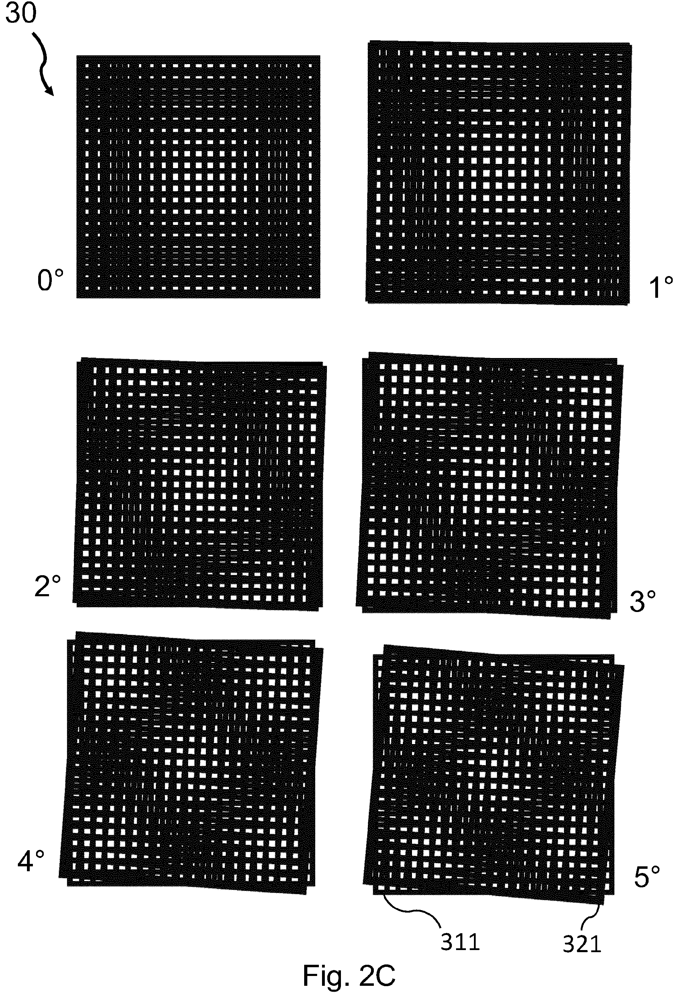

**Fig. 2C** zeigt beispielhaft die relativen Verdrehungen der beispielhaften Gittermuster 311, 312 von 0° bis 5°. Die Veränderungen in den überlagerten Gittermustern erlauben es somit ebenfalls relative Verdrehungen festzustellen. Es kommt hierbei nicht zu einer reinen Verschiebung der Helligkeitsverteilung. Durch den Moire-Effekt entstehen zusätzliche, lokale Intensitätsmaxima, aus deren Anordnung ein relativer Drehwinkel ablesbar ist. Aus den Positionen (z.B. des Mittelpunktes) dieser zusätzlichen Intensitätsmaxima kann der relative Drehwinkel abgelesen werden. Dieser Zusammenhang kann berechnet oder einfach durch eine Kalibrierung für ein konkretes Muster bestimmt werden. In Ergänzung zur Auswertung der Positionen und Winkel der einzelnen Intensitätsmaxima ist es möglich, auch den Winkel der Verbindungslinien von Intensitätsmaxima relativ zum Rand zu einer Referenzebene (beispielsweise Marker, Grundstruktur oder Drucker) auszuwerten.

Die Größe des beispielhaften Nonius-Gitters 311,321 kann derart gewählt werden, dass eine Augenoptische Analyse möglich ist. Z.B. können sie eine Größe von 10 x 10 mm betragen. Gemäß Ausführungsbeispielen können mit dem Nonius-Muster 310, 320 Abweichungen in X- und von zumindest +/- 0,5 mm erfasst werden. Weitere Ausführungsbeispiele ermöglichen aber eine deutlich bessere Auflösung. So können z.B. Messgenauigkeiten von +/- 0,05 mm erreicht werden, wobei Abweichungen in beide Richtungen erfasst werden können. Beispielsweise kann der Gitterabstand (oder die Maschenweite) des Nonius-Gitters ein Wert von 1/10 mm (100 µm) und des engmaschigeren Nonius-Gitters von 1/9 mm (111 µm) betragen.

Die Größe des Gitters und der Gitterabstand können aber frei gewählt werden bzw. in Abhängigkeit von einer erwarteten Abweichung eingestellt werden.

Die folgenden Abmaße haben sich bei der Betrachtung mit dem Auge als vorteilhaft erwiesen:

| | |
|---|---|
| - Gittergröße: | 10 mm |
| - Linienanzahl: | 20 |
| - Gitterabstand: | klein 500 µm |
| - Gitterabstand: | groß 525 µm |
| - Linienbreite: | 0,15 mm |

Diese Parameter stellen nur eine mögliche Ausgestaltung dar. Insbesondere können bei der automatisierten Erfassung des Versatzes mittels eines optischen Sensors (z.B. einer Kamera) andere Abmaße gewählt werden, die z.B. von dem Sensor abhängen (z.B. Auflösung der Kamera).

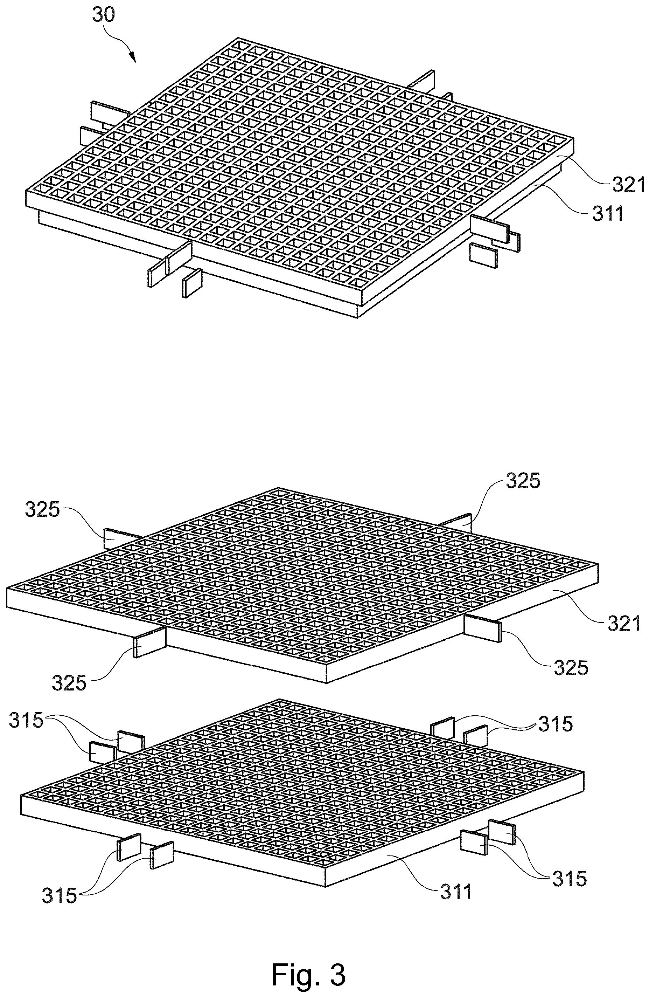

**Fig. 3** zeigt eine Raumansicht der Nonius-Gitter 311, 321, wie sie gemäß Ausführungsbeispielen genutzt werden können. In der Fig. 3 unten ist zunächst das erste Nonius-Gitter 311 dargestellt, wie es beispielhaft auf dem ersten Teilkörper 10 ausgebildet sein kann. Das erste Nonius-Gitter 311 umfasst wiederum die Bereichsmarker 315 als Außenmarker, die ausgebildet sind, um einen Versatz größer einer Gitterperiode des ersten Teilkörper 10 relativ zu dem zweiten Teilkörper 20 festzustellen. Das zweite Nonius-Gitter 321 umfasst ebenfalls ein rechteckförmiges Gittermuster, das allerdings einem leicht abweichenden Gitterabstand aufweist, sodass nach dem Nonius-Prinzip ein leichter Versatz feststellbar ist. Außerdem umfasst das zweite Nonius-Gitter 321 mehrere Strichmarken 325 als Außenmarker, die bei einer genauen Positionierung des ersten Teilkörpers 10 zu dem zweiten Teilkörper 20 möglichst mittig in dem Bereich des Bereichsmarker 315 angeordnet ist. Die Fig. 3 oben zeigt eine Raumansicht der beiden übereinander liegenden Nonius-Gitter 311, 321. In der Draufsicht ergibt sich dann beispielsweise die Darstellung aus der Fig. 2B.

Wie bereits dargelegt kann die Erfassung des Versatzes auch automatisch geschehen, beispielsweise durch eine Kamera. So kann in der Fig. 2B der hell durchscheinende Bereich als Bereich hoher Lichtintensität durch die Kamera erfasst werden. Eine Auswerteeinheit kann auch feststellen, ob sich der helle Bereich (= Maximum der Intensität) in der Mitte befindet oder verschoben ist. Große Verschiebungen können über Kontrollmarkierungen 315, 325 an den Außenseiten auch durch die Kamera erfasst werden. Hierzu kann die Kamera ausgebildet sein, um die Helligkeitsverteilung auf dem Bild zu erkennen. Wenn eine Verschiebung des ersten Teilkörpers 10 relativ zu dem zweiten Teilkörper 20 vorliegt, ist das Maximum der Transparenz nicht dort wo es bei genauer Positionierung zu erwarten ist (z.B. mittig), sondern relativ in einer Richtung verschoben, die den Versatz der beiden Teilkörper 10, 20 anzeigt.

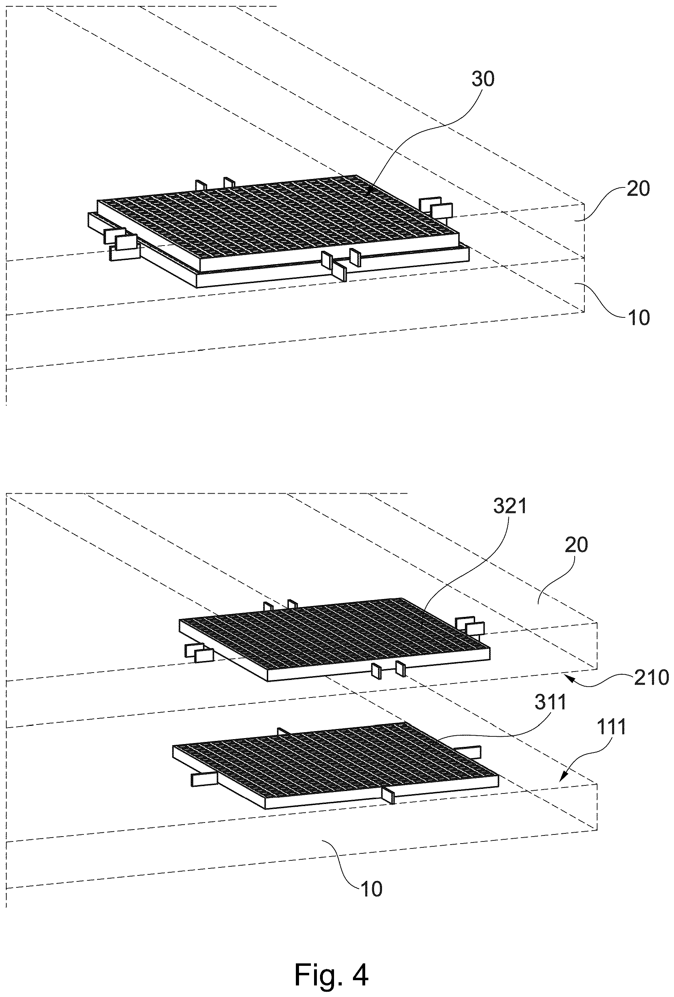

**Fig. 4** zeigt eine mögliche Anordnung der Nonius-Gitter 311, 321 aus der Fig. 3 in dem ersten Teilkörper 10 bzw. in dem zweiten Teilkörper 20. Unten in der Fig. 4 wurde der erste Teilkörper 10 von dem zweiten Teilkörper 20 verschoben, um die jeweilige Anordnung besser zu veranschaulichen. Es versteht sich, dass der zweite Teilkörper 20 auf dem ersten Teilkörper 10 additiv gefertigt wird, sodass sie im Allgemeinen nicht trennbar sind.

Bei der additiven Fertigung wird das erste Nonius-Gitter 311 beispielsweise auf einer Oberseite 110 des ersten Teilkörpers 10 und das zweite Nonius-Gitter 321 wird auf einer Unterseite 210 des zweiten Teilkörpers 20 ausgebildet, wobei Begriffe wie "oben" und "unten" durch die Fertigungsrichtung definiert werden können. Dadurch wird es möglich, dass das erste Nonius-Gitter 311 und das zweite Nonius-Gitter 321 möglichst nahe aneinander liegen, sodass Parallaxenfehler minimiert werden können. Gemäß weiteren Ausführungsbeispielen wird dies ebenfalls für die Nonius-Skalen in der Fig. 1 bzw. der Fig. 2A gemacht. Auch dort ist es möglich, die Nonius-Skalen 312, 322 jeweils auf einer Oberseite des ersten Teilkörpers 10 bzw. Unterseite des zweiten Teilkörpers 20 zu bilden, um einen Parallaxenfehler zu minimieren.

In der Fig. 4 oben ist die fertiggestellte Struktur dargestellt, wobei unterhalb des zweiten Teilkörpers 20 der erste Teilkörper 10 gefertigt ist und die beiden Nonius-Gitter 311, 321 aneinandergrenzen.

Das Auslesen der Positionsabweichung braucht aber nicht nur über optische Messverfahren geschehen. Es kann auch über eine elektrische Erfassung erfolgen.

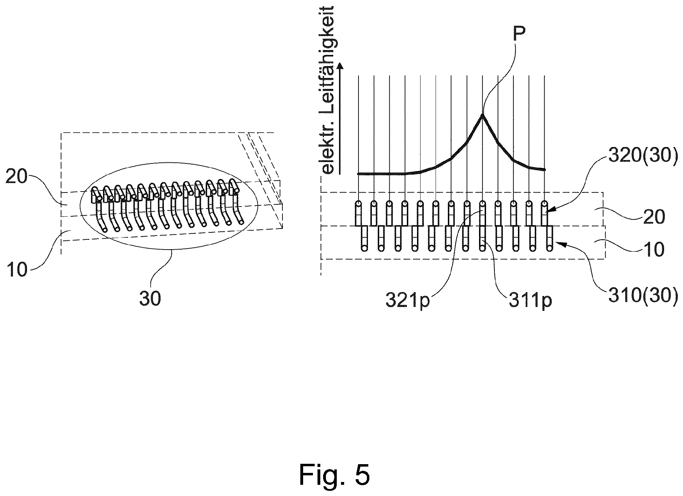

**Fig. 5** zeigt ein entsprechendes Ausführungsbeispiel, bei dem die Erfassung des Versatzes nicht optisch durch ein Erkennen eines Musterversatzes erfolgt, sondern über eine elektrische Messung. Beispielsweise ist es möglich, dass die Gitter 311, 321 oder die Strichskalen 312, 322 als elektrisch leitfähige Elemente ausgebildet werden. Je nachdem wie stark sie einander überlappen, ändert sich ein elektrischer Widerstand bzw. eine Kapazität für ein durchgeleitetes Signal. So wird ein Maximum des elektrischen Stromflusses (=Minimum des elektrischen Widerstandes) genau dort sein, wo einzelnen Elemente der beispielhaften Nonius-Skalen 312, 322 maximal ausgerichtet sind (maximal überlappen). Dies ist in der Fig. 4 (siehe rechte Seite) an der Position P der Fall. Dort sind die Strichelemente 311p, 322p entlang einer Linie ausgerichtet.

Die Position dieses Maximums der Leitfähigkeit kann durch eine elektronische Schaltung ermittelt werden und zeigt an, in welchem Maße der zweite Teilkörper 20 von dem ersten Teilkörper 10 versetzt ist. Je nachdem wie der Positionsmarker 30 geeicht ist, kann eine Überstimmung in einem bestimmten Strich (z.B. in der Mitte) eine genaue Positionierung anzeigen, während jeder Strich auf beiden Seiten einen zunehmenden Versatz anzeigt.

Es ist ebenfalls möglich, dass nicht der elektrische Widerstand, sondern eine kapazitive oder induktive Messung erfolgt. Im Allgemeinen kann eine Impedanz gemessen werden, wobei kleinste Änderungen z.B. in einer Verschiebung einer Resonanzfrequenz messbar sind.

Die Kontaktierung kann über eine Außenwand (z.B. Stirnfläche in der Fig. 5) erfolgen und die Nonius-Muster 310, 320 sind über elektrisch-leitfähige Bahnen kontaktiert, die elektrische Verbindungen zu der Außenwand herstellen. Als Außenwand kommt hierbei sowohl eine seitliche Fläche als auch eine obere und untere Flächen infrage. Damit wird also ein Mapping über alle Kontaktstellen durchgeführt. Das Maximum der Leitfähigkeit kann dann automatisch ermittelt werden. Ähnlich wie bei der optischen Überprüfung der Nonius-Striche/-Gitter stellt die Position des Maximums den relativen Versatz dar. Es versteht sich, dass mit einer solchen Messung Verschiebungen in beiden horizontale Richtungen X, Y möglich sind, da Verschiebungen in beiden Richtungen zu einer Änderung des Überlapps führen. Zur Erhöhung der Genauigkeit kann ein Punktmuster in beiden Richtungen ausgebildet werden, wobei in beiden Richtungen eine Skalierung erfolgt, um den Nonius-Effekt zu erreichen.

Gemäß weiteren Ausführungsbeispielen ist zumindest ein Nonius-Muster 310, 320 nicht in die zu fertigende Struktur integriert, sondern ist als separates Objekt ausgebildet, um eine Überwachung des gesamten Druckjobs (ggf. für mehrere Platinen) zu ermöglichen. Beispielsweise kann eines der beiden Nonius-Muster 310, 320 nicht in dem ersten oder in dem zweiten Teilkörper 10, 20 ausgebildet werden, sondern ist an der Vorrichtung zur additiven Fertigung vorhanden. So kann beispielsweise das erste Nonius-Muster 310 zunächst auf dem ersten Teilkörper 10 (z.B. auf einer Seitenfläche) ausgebildet werden. Dann kann der erste Teilkörper 10 aus der Fertigungsvorrichtung entnommen werden, um die elektronische Komponente 15 anzubringen. Nach dem Einsetzen des ersten Teilkörpers 10 zusammen mit der elektronischen Komponente 15 in die Vorrichtung zur additiven Fertigung kann beispielsweise über eine Nonius-Muster 320 an dem Druckkopf der Fertigungsvorrichtung festgestellt werden, ob die Ausrichtung relativ zu der Druckvorrichtung immer noch wie gewünscht ist oder ob eine Korrektur angeraten ist, um den zweiten Teilkörper 20 mit hoher Genauigkeit auf dem ersten Teilkörper 10 additiv zu fertigen.

An der Vorrichtung zur additiven Fertigung kann hierfür auch eine separate Kalibrierskala vorgesehen sein, die für mehrmalige Positionsmessungen geeignet ist. Wenn beispielsweise drei oder mehr Teilkörper übereinander zu fertigen sind, wobei zwischen den jeweiligen Teilkörpern elektrische Bauteile mittels eine Bestück-Maschine einzusetzen sind, kann bei jedem erneuten Einsetzen in die Vorrichtung zur additiven Fertigung ein Versatz durch den bereits vorhandenen Positionsmarker 30 festgestellt werden.

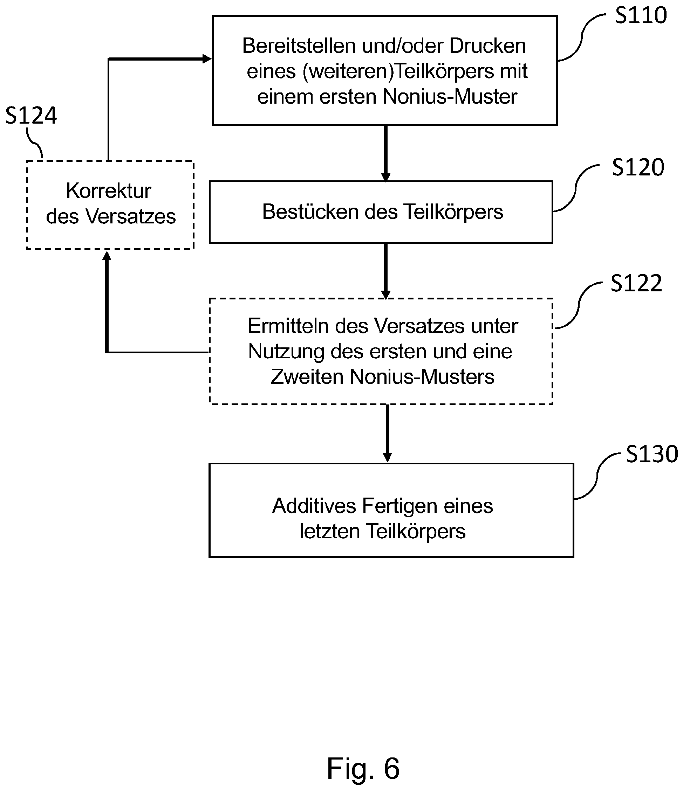

**Fig. 6** zeigt ein schematisches Flussdiagramm zur Herstellung einer Struktur. Die hergestellte Struktur kann insbesondere ein Schaltungsträger oder eine Platine sein, die z.B. einen Teil einer 3D-Elektronik bildet. Das Verfahren umfasst die Schritte:
- Bereitstellen S110 eines Teilkörpers mit einem ersten Nonius-Muster, wobei das Bereitstellung insbesondere ein additives Fertigen umfassen kann;
- Bestücken S120 des Teilkörpers mit einer elektronischen Komponente;
- Additives Fertigen S130 eines letzten (oder eines zweiten) Teilkörpers.

Ein zweites Nonius-Muster wird auf dem letzten Teilkörper gefertigt. Das erste Nonius-Muster und das zweite Nonius-Muster bilden den Positionsmarker, um einen relativen Versatz zwischen den Teilkörpern anzuzeigen.

Optional umfasst das Verfahren weiter:
- Ermitteln S122 eines Versatzes unter Nutzung des Positionsmarkes,
- Korrektur S124 des ermittelten Versatzes.

Dann kann das Verfahren mit dem Fertigen (Drucken) eines weiteren Teilkörpers fortgesetzt werden, wobei beim Durchlaufen einer jeden Schleife eine Korrektur durchgeführt werden kann. Im einfachsten Fall wird nur ein erster Teilkörper 10 gefertigt/bereitgestellt, auf dem ein zweiter Teilkörper 20 gedruckt wird.

Bei dem Schritt des additiven Fertigens des ersten Teilkörpers 10 wird insbesondere der erste Teilkörper 10 zusammen mit dem ersten Nonius-Muster 310 im oder am ersten Teilkörper 10 gefertigt. Der erste Teilkörper 10 kann auch eine konventionell gefertigte Leiterplatte sein oder diese umfassen (die nicht, teilweise oder voll bestückt), in welche in einem konventionellen Fertigungsverfahren das erste Nonius-Muster 310 eingebracht wurde. Der konventionell hergestellte Schaltungsträger kann beispielsweise eine Leiterplatte aus z.B. FR4 (Epoxidharz und Glasfaser), Polymer oder Keramik sein.

Wie bereits geschrieben erfolgt gemäß weiteren Ausführungsbeispielen die Fertigung des zweiten Teilkörpers 20 auf dem ersten Teilkörper 10 nicht sofort.

Der erste Teilkörper 10 kann zum Bestücken mit der elektronischen Komponente 15 aus der Fertigungsvorrichtung herausgenommen wird. Nach dem erneuten Einsetzen kann ein möglicher Versatz zunächst festgestellt und vor dem Weiterdruck eine Korrektur des festgestellten Versatzes erfolgen. Konkret kann nach der Bestückung mit der elektronischen Komponente 15 zunächst der Abschnitt des zweiten Teilkörpers 20 mit dem zweiten Nonius-Muster 320 auf dem ersten Teilkörper 10 gefertigt werden. Dann wird der relative Versatz festgestellt. Danach erfolgt die optionale Korrektur der Druckausrichtungen bzw. des Versatzes. Zum Schluss wird der zweite Teilkörper 20 fertiggestellt. Dieses Nachjustieren vor Fertigstellung des Druckjobs bietet den Vorteil, dass unzureichende Durchkontaktierungen infolge der detektierten Abweichungen in der Position vermieden werden können.

Das Bestücken des ersten Teilkörpers 10 mit dem zumindest einen elektronischen Bauelement erfolgt im Allgemeinen außerhalb des 3D-Druckers. Es kann aber auch innerhalb des 3D-Druckers erfolgen. In beiden Fällen führen Unterbrechungen des Druckprozess u.a. zu thermischen Schwankungen und hierdurch zu sprunghaften Positionsabweichungen. Die Positionierung gemäß Ausführungsbeispielen unter Nutzung des Positionsmarkers 30 kann auch entsprechend zur Kalibrierung von nachfolgenden Prozessen verwendet werden (z. B. von Bestückungen in pick & place). Das Ermitteln des Positionsversatzes kann auch unmittelbar vor dem Weiterdrucken des zweiten Teilkörpers 20 erfolgen, um so z.B. weitere thermisch bedingte weitere Positionsabweichungen zu minimieren.

Die bereits genannten Messverfahren zum Ermitteln des Positionsversatzes können wie folgt konkret umgesetzt werden:

### A. Optisches Messverfahren

Drucken des zweiten Nonius-Musters 320 auf das erste Nonius-Muster 310. Um Kollisionen des Druckkopfs mit dem Werkstück auszuschließen, kann hierbei der Abstand des tiefsten Punkts des Druckkopfs zur Druckfläche deutlich größer gewählt werden als eine Schichtdicke des Druckprozesses. Dazu wird gemäß Ausführungsbeispielen ein Höhenoffset des Druckkopfes berücksichtigt. Anschließend kann der Positionsversatz optisch erfasst werden.

### B. Elektronisches Messverfahren

Die durch unterschiedliche Überlappungen entstehenden unterschiedlichen elektrischen Widerstände können elektrisch direkt gemessen werden. Außerdem können auch Kapazitäts-/Induktivitätsmessung vorgenommen werden. Dazu kann am Druckkopf, vorzugsweise in der Nähe der Druckdüsen, eine Messvorrichtung zur kapazitiven oder induktiven Erfassung der Messabweichung angebracht werden. Kapazitive und induktive Messverfahren sind dem Fachmann bekannt (z.B. für Messschieber), wobei deren Genauigkeit +/- 0,02 mm = +/-20 µm beträgt. Mit dieser Genauigkeit ergibt sich eine Messgenauigkeit auf dem Niveau einer Druckerauflösung bekannten 3D-Drucker im Bereich von 600 dpi (25,4 mm / 600 = 42,3 µm). Da sich die Messgenauigkeit somit im Bereich einer Pixelbreite bewegt, ist das Messverfahren ausreichend präzise. Um möglichst wenig Bauraum hierfür zu verbrauchen können die elektrischen Leiter des Positionsmarkers 30 in der Nähe einer Seitenfläche des beispielhaften Schaltungsträgers angebracht sein. Zur Erfassung der Positionsabweichung in X- und können zwei vorzugsweise rechtwinklig zueinander angeordnete Messsysteme vorgesehen sein.

Die Erfassung des Messwertes (Versatz) kann gemäß Ausführungsbeispielen mittels Linearencoder erfolgen. Dieser kann wegen des geringen Leistungsbedarfs kapazitiv und in geringerem Ausmaß auch induktiv arbeiten. Zur kapazitiven Erfassung kann ein periodisch angeordnetes Muster (z.B. erstes Nonius-Muster 310) in Form einer elektrischen Leiterbahn genutzt werden, die Platten von Kondensatoren bilden. Durch gegenüberliegend angebrachte Metallstreifen (z.B. zweites Nonius-Muster 320), erfolgt eine Signalgebung mit mehreren, verschiedenartigen pulsweitenmodulierten Rechtecksignalen, welche von der Ansteuerelektronik gebildet werden. Je nach der relativen Position der so gebildeten Muster ergeben sich durch die unterschiedlichen kapazitiven Kopplungen der geometrischen Anordnung verschiedenartige Signalverläufe an der Empfangselektrode. Mittels einer digitalen Signalverarbeitung kann daraus die genaue relative Position des ersten Nonius-Muster 310 und des zweiten Nonius-Muster 320 ermittelt und ausgegeben werden.

Bei den Verfahren und eingesetzten Linearencodern gibt es verschiedene Methoden und Realisierungsarten. Grob lassen sich die verwendeten Linearencoder neben dem physikalischen Prinzip (kapazitiv und induktiv) in relative und absolute Encoder einteilen. Bei relativen Linearencodern erfolgt vor einer Messung eine Einstellung des Nullpunktes (Kalibrierung). Der Versatz wird dann durch einen Zähler in der Elektronik relativ zu diesem Nullpunkt ermittelt. Durch die Elektronik, z.B. durch eine eingesetzte CMOS-Schaltungstechnik, wird hier nur sehr wenig Energie verbraucht, sodass keine negativen Einwirkungen auf die anderen elektronischen Komponenten 15 auf der Schaltungsplatine zu erwarten sind. Bei den absoluten Linearencodern ist die Positionsinformation in der Art der Anordnung der Strukturen im Encoder festgelegt, eine Nullpunkteinstellung ist nicht nötig. Gemäß weiteren Ausführungsbeispielen können die genutzten Linearencoder eine serielle Datenschnittstelle aufweisen, welche als RS-232-Schnittstelle ausgeführt sein kann, die den automatischen Abgriff des Versatzes für die externe Speicherung oder Anzeige an größeren, externen Anzeigen erlaubt.

Nachdem der Positionsversatz ermittelt wurde, kann das Weiterdrucken mit optimierten Positionsparametern erfolgen. Hierzu können ermittelte Offsetparameter in den Druckprozess eingebracht werden, sodass die Positionsabweichung korrigiert wird und die Gefahr von Fehldrucken sich damit reduziert.

Somit wird der Positionsmarker 30 nicht nur zur Bestimmung des Positionsversatzes beim 3D-Druck herangezogen. Insbesondere soll auch die ermittelte Positionsabweichung, hervorgerufen durch die Unterbrechung des Druckprozesses, vor dem Weiterdrucken korrigiert werden. Hierdurch ist nicht nur eine gut/schlecht - Prüfung in Nachhinein möglich, sondern auch eine aktive Erhöhung der Job-on-Job - Präzision.

Gemäß weiterer Ausführungsbeispiele kann der Positionsmarker 30 bzw. dessen Position in einem weiteren Marker kodiert sein, um das Auffinden zu erleichtern. Der weitere Marker kann ähnlich einem QR-Code eine automatische Erfassung ermöglichen, wobei der automatisch zu der Position des Positionsmarkers 30 geleitet wird, die dem weiteren Marker kodiert ist.

### BEZUGSZEICHENLISTE

- 10: erster additiv-gefertigter Teilkörper
- 110: Oberseite vom ersten Teilkörper
- 15: zumindest eine elektronische Komponente
- 20: zweiter additiv-gefertigter Teilkörper
- 210: Unterseite vom zweiten Teilkörper
- 30: Nonius-basierten Positionsmarker
- 310,320: Nonius-Muster
- 311,321: Nonius-Gitter
- 312,322: Nonius-Skala
- 315,325: Außenmarker
- Z: (vertikale) Fertigungsrichtung
- X,Y: (horizontale) Richtungen senkrecht zur Fertigungsrichtung

## Patentansprüche

1. Eine Struktur, aufweisend eine additiv gefertigte Elektronik bei der mindestens zwei Tinten verarbeitet werden, die Folgendes umfasst:
mehrere Teilkörper (10, 20) mit einem ersten Teilkörper (10) und einem zweiten Teilkörper (20), die zumindest eine elektronische Komponente (15) aufweisen, wobei der zweite Teilkörper (20) zumindest teilweise auf dem ersten Teilkörper (10) additiv gefertigt ist; und
einen Nonius-basierten Positionsmarker (30), der ausgebildet ist, um einen relativen Versatz zwischen dem ersten Teilkörper (10) und den zweiten Teilkörper (20) anzuzeigen, wozu zwei Muster in die beiden Teilkörper (10, 20) eingebracht sind.

2. Die Struktur nach Anspruch 1, wobei der Positionsmarker (30) ein erstes Nonius-Muster (310) und ein zweites Nonius-Muster (320) aufweist, wobei das erste Nonius-Muster (310) auf dem ersten Teilkörper (10) und das zweite Nonius-Muster (320) auf dem zweiten Teilkörper (20) ausgebildet ist.

3. Die Struktur nach Anspruch 2, wobei das erste Nonius-Muster (310) auf einer Oberseite (110) des ersten Teilkörpers (10) und das zweites Nonius-Muster (320) auf einer Unterseite (210) des zweiten Teilkörpers (20) ausgebildet ist, wobei die Unterseite (210) und die Oberseite (110) einander zugewandt sind.

4. Die Struktur nach Anspruch 2 oder Anspruch 3, wobei das erste Nonius-Muster (310) und das zweite Nonius-Muster (320) jeweils ein Gitter (311, 321) oder jeweils zumindest eine Nonius-Skala (312, 322) umfassen, um einen Versatz in einer oder beiden Richtungen (X,Y) senkrecht zur additiven Fertigungsrichtung (Z) anzuzeigen.

5. Die Struktur nach Anspruch 4, wobei die zumindest eine Nonius-Skala (312, 322) zumindest eine erste Seitenskala (312) auf einer Seitenfläche des ersten Teilkörpers (10) und zumindest eine zweite Seitenskala (322) auf einer Seitenfläche des zweiten Teilkörpers (20) aufweist, wobei Seitenflächen eine seitliche Begrenzung der Struktur bilden.

6. Die Struktur nach einem der vorhergehenden Ansprüche, wobei die Teilkörper (10, 20) zumindest an einer Position des Positionsmarkers (30) ein transparentes Material aufweisen, um eine optische Erfassung mittels eines optischen Sensors zu ermöglichen.

7. Die Struktur nach einem der vorhergehenden Ansprüche, wobei die Teilkörper (10, 20) zumindest an einer Position des Positionsmarkers (30) ein dielektrisches Material und der Positionsmarker (30) elektrisch leitfähiges Material aufweist, um eine elektrische Erfassung des Versatzes zu ermöglichen.

8. Die Struktur nach Anspruch 7, wobei der Positionsmarker (30) einen Linearencoder umfasst.

9. Die Struktur nach einem der vorhergehenden Ansprüche, wobei der Positionsmarker (30) ein erster Positionsmarker ist und die Struktur zusätzlich einen zweiten Nonius-basierten Positionsmarker aufweist, der von dem ersten Positionsmarker (30) beabstandet ist, um eine Messgenauigkeit zu erhöhen oder eine Verdrehung festzustellen.

10. Vorrichtung, umfassend Mittel zur Ausführung der Schritte des Verfahrens nach Anspruch 11.

11. Ein Verfahren zur additiven Fertigung einer Struktur, aufweisend eine additiv gefertigte Elektronik bei der mittels einer additiven Fertigungsvorrichtung mindestens zwei Tinten verarbeitet werden, die folgende Schritte umfasst:
Bereitstellen eines ersten Teilkörpers (10) mit einem ersten Nonius-Muster (310);
Bestücken des ersten Teilkörpers (10) mit einer elektronischen Komponente (15);
Additives Fertigen eines zweiten Teilkörpers (20), wobei ein zweites Nonius-Muster (320) auf dem zweiten Teilkörper (20) gefertigt wird, und
wobei das erste Nonius-Muster (310) und ein zweites Nonius-Muster (320) einen Positionsmarker (30) bilden, um einen relativen Versatz zwischen dem ersten Teilkörper (10) und den zweiten Teilkörper (20) anzuzeigen.

12. Das Verfahren nach Anspruch 11, wobei das Bereitstellen eines ersten Teilkörpers (10) mit einem ersten Nonius-Muster (310) ein additives Fertigen des ersten Teilkörpers (10) zusammen mit dem ersten Nonius-Musters (310) umfasst, und wobei das Bestücken des ersten Teilkörpers (10) folgendes umfasst:
Entnahme des additiv-gefertigten ersten Teilkörper (10) aus einer additiven Fertigungsvorrichtung;
Bestücken des ersten Teilkörper (10) mit der elektronischen Komponente (15); und
Wiedereinsetzen des ersten Teilkörpers (10) zusammen mit der elektronischen Komponente (15) in die additive Fertigungsvorrichtung.

## Claims

1. A structure comprising additively manufactured electronics in which at least
two inks are processed, comprising the following:
a plurality of partial bodies (10, 20) comprising a first partial body (10) and a second partial body (20) having at least one electronic component (15), wherein the second partial body (20) is at least partially additively manufactured on the first partial body (10); and
a vernier-based position marker (30) designed to indicate a relative offset between the first partial body (10) and the second partial body (20), for which purpose two patterns are introduced into the two partial bodies (10, 20).

2. The structure according to claim 1, wherein the position marker (30) has a first vernier pattern (310) and a second vernier pattern (320), wherein the first vernier pattern (310) is formed on the first partial body (10) and the second vernier pattern (320) is formed on the second partial body (20).

3. The structure according to claim 2, wherein the first vernier pattern (310) is formed on an upper face (110) of the first partial body (10) and the second vernier pattern (320) is formed on a lower face (210) of the second partial body (20), wherein the lower face (210) and the upper face (110) face each other.

4. The structure according to claim 2 or claim 3, wherein the first vernier pattern (310) and the second vernier pattern (320) each comprise a grating (311, 321) or at least one vernier scale (312, 322) to indicate an offset in one or both directions (X,Y) perpendicular to the additive manufacturing direction (Z).

5. The structure according to claim 4, wherein the at least one vernier scale (312, 322) has at least one first side scale (312) on a side surface of the first partial body (10) and at least one second side scale (322) on a side surface of the second partial body (20), wherein side surfaces form a lateral boundary of the structure.

6. The structure according to any of the preceding claims, wherein the partial bodies (10, 20) comprise a transparent material at least at one position of the position marker (30) in order to allow optical detection by means of an optical sensor.

7. The structure according to any of the preceding claims, wherein the partial bodies (10, 20) comprise a dielectric material at least at one position of the position marker (30) and the position marker (30) comprises electrically conductive material in order to allow electrical detection of the offset.

8. The structure according to claim 7,
wherein the position marker (30) comprises a linear encoder.

9. The structure according to any of the preceding claims, wherein the position marker (30) is a first position marker and the structure additionally comprises a second vernier-based position marker spaced from the first position marker (30) in order to increase measurement accuracy or detect rotation.

10. An apparatus comprising means for carrying out the steps of the method according to claim 11.

11. A method for additively manufacturing a structure, comprising additively manufactured electronics in which at least two inks are processed by means of an additive manufacturing apparatus, comprising the following steps:
Providing a first partial body (10) with a first vernier pattern (310);
Equipping the first partial body (10) with an electronic component (15);
Additively manufacturing a second partial body (20), wherein a second vernier pattern (320) is manufactured on the second partial body (20), and
wherein the first vernier pattern (310) and a second vernier pattern (320) form a position marker (30) in order to indicate a relative offset between the first partial body (10) and the second partial body (20).

12. The method according to claim 11,
wherein the provision of a first partial body (10) with a first vernier pattern (310) comprises additively manufacturing the first partial body (10) together with the first vernier pattern (310), and
wherein the assembly of the first partial body (10) comprises the following:
Removing the additively manufactured first partial body (10) from an additive manufacturing apparatus;
Equipping the first partial body (10) with the electronic component (15); and
Reinserting the first partial body (10) together with the electronic component (15) into the additive manufacturing apparatus.

## Revendications

1. Structure, présentant une électronique fabriquée par fabrication additive dans laquelle au moins
deux encres sont traitées, lesquelles comprennent les éléments suivants :
plusieurs corps partiels (10, 20) comportant un premier corps partiel (10) et un second corps partiel (20), lesquels présentent au moins un composant électronique (15), dans laquelle le second corps partiel (20) est fabriqué par fabrication additive au moins partiellement sur le premier corps partiel (10) ; et
un marqueur de position (30) basé sur un vernier et conçu pour indiquer un décalage relatif entre le premier corps partiel (10) et le second corps partiel (20), moyennant quoi deux motifs sont introduits dans les deux corps partiels (10, 20).

2. Structure selon la revendication 1, dans laquelle le marqueur de position (30) présente un premier motif de vernier (310) et un second motif de vernier (320), dans laquelle le premier motif de vernier (310) est réalisé sur le premier corps partiel (10) et le second motif de vernier (320) est réalisé sur le second corps partiel (20).

3. Structure selon la revendication 2, dans laquelle le premier motif de vernier (310) est réalisé sur une face supérieure (110) du premier corps partiel (10) et le second motif de vernier (320) est réalisé sur une face inférieure (210) du second corps partiel (20), dans laquelle la face inférieure (210) et la face supérieure (110) se font face.

4. Structure selon la revendication 2 ou la revendication 3, dans laquelle le premier motif de vernier (310) et le second motif de vernier (320) comprennent respectivement une grille (311, 321) ou respectivement au moins une échelle de vernier (312, 322) afin d'indiquer un décalage dans une ou les deux directions (X, Y) perpendiculairement à la direction de fabrication additive (Z).

5. Structure selon la revendication 4, dans laquelle l'au moins une échelle de vernier (312, 322) présente au moins une première échelle latérale (312) sur une surface latérale du premier corps partiel (10) et au moins une seconde échelle latérale (322) sur une surface latérale du second corps partiel (20), dans laquelle des surfaces latérales forment une limite latérale de la structure.

6. Structure selon l'une des revendications précédentes, dans laquelle les corps partiels (10, 20) présentent un matériau transparent au moins à une position du marqueur de position (30) afin de permettre une détection optique au moyen d'un capteur optique.

7. Structure selon l'une des revendications précédentes, dans laquelle le corps partiel (10, 20) présente un matériau diélectrique au moins à une position du marqueur de position (30) et le marqueur de position (30) présente un matériau électriquement conducteur afin de permettre une détection électrique du décalage.

8. Structure selon la revendication 7,
dans laquelle le marqueur de position (30) comprend un codeur linéaire.

9. Structure selon l'une des revendications précédentes, dans laquelle le marqueur de position (30) est un premier marqueur de position et la structure comprend en outre un second marqueur de position basé sur le vernier espacé du premier marqueur de position (30) afin d'augmenter la précision de la mesure ou de détecter une torsion.

10. Dispositif, comprenant des moyens pour la réalisation des étapes du procédé selon la revendication 11.

11. Procédé pour la fabrication additive d'une structure, présentant une électronique fabriquée par fabrication additive dans laquelle au moins deux encres sont traitées au moyen d'un dispositif de fabrication additive, comprenant les étapes suivantes :
fourniture d'un premier corps partiel (10) comportant un premier motif de vernier (310) ;
équipement du premier corps partiel (10) d'un composant électronique (15) ;
fabrication par fabrication additive d'un second corps partiel (20), dans lequel un second motif de vernier (320) est fabriqué sur le second corps partiel (20), et
dans lequel le premier motif de vernier (310) et un second motif de vernier (320) forment un marqueur de position (30) afin d'indiquer un décalage relatif entre le premier corps partiel (10) et le second corps partiel (20).

12. Procédé selon la revendication 11,
dans lequel la fourniture d'un premier corps partiel (10) comportant un premier motif de vernier (310) comprend la fabrication additive du premier corps partiel (10) conjointement avec le premier motif de vernier (310), et
dans lequel l'équipement du premier corps partiel (10) comprend ce qui suit :
retrait du premier corps partiel (10) fabriqué par fabrication additive d'un dispositif de fabrication additive ;
équipement du premier corps partiel (10) du composant électronique (15) ; et
réintroduction du premier corps partiel (10) avec le composant électronique (15) dans le dispositif de fabrication additive.
